Europäisches Patentamt

European Patent Office

Office européen des brevets

(19)

(11) Publication number: **0 176 693**
A2

# EUROPEAN PATENT APPLICATION

(12)

(21) Application number: **85109628.9**

(22) Date of filing: **21.02.83**

(51) Int. Cl.⁴: **C 23 C 14/58**
**B 05 D 1/00, B 05 D 5/00**

(30) Priority: **22.02.82 US 350437**
**22.02.82 US 350722**
**22.02.82 US 350724**

(43) Date of publication of application:
**09.04.86 Bulletin 86/15**

(84) Designated Contracting States:
**BE CH DE FR GB IT LI**

(60) Publication number of the earlier application
in accordance with Art. 76 EPC: **0 087 309**

(71) Applicant: **MINNESOTA MINING AND MANUFACTURING COMPANY**
**3M Center**
**Saint Paul, Minnesota 55101(US)**

(72) Inventor: **Cederberg, Barbara M.**
**c/o Minnesota Mining & Manufacturing Co. 3M Center**
**Saint Paul Minnesota 55133(US)**

(72) Inventor: **Downing, Edward J.**
**c/o Minnesota Mining & Manufacturing Co. 3M Center**
**Saint Paul Minnesota 55133(US)**

(72) Inventor: **Fisch, Richard S.**
**c/o Minnesota Mining & Manufacturing Co. 3M Center**
**Saint Paul Minnesota 55133(US)**

(74) Representative: **Bowman, Paul Alan et al,**
**LLOYD WISE, TREGEAR & CO. Norman House 105-109 Strand**
**London WC2R OAE(GB)**

(54) **Process for protecting vapor-deposited metal layers.**

(57) A process for improving the abrasion resistance of vapour deposited metal layers which comprises vapour depositing a metal or metalloid layer on at least one surface of a substrate, and before subjecting the metal layer to physical treatment or contact which would abrade the metal layer, vapour depositing onto said metal layer a 1 to 600 nm layer of organic material having a vapour pressure at 20°C equal to or less than that of 1-n-octanol, said material having a) a carbonyl group not part of a carboxyl group, b) a phenoxy group, c) an ester group, or d) an alcohol group. The organic materials can improve the properties of the metal layer when used in photoresist imaging films.

EP 0 176 693 A2

PROCESS FOR PROTECTING VAPOR-DEPOSITED METAL LAYERS

## BACKGROUND OF THE INVENTION
### Field of the Invention

This invention relates to vapor-deposited metal layers which are protected from damage by the application of an organic layer to its surface. The invention further relates to the process of applying the protective organic layer to the surface of the vapor-deposited metal layer and to the photosensitive articles made with the protected metal layer.

In particular, the present invention relates to the application of an organic layer onto the surface of a vapor deposited metal layer. The metal layer is generally formed on a supporting base by any of the various vapor-depositing techniques. Prior to subjecting the deposited metal layer to any physical treatments or stress likely to damage the continuity of the coating (e.g., rolling, folding, bending, and the like) an organic layer is vapor deposited onto the surface of the metal.

### Description of the Prior Art

Vapor-deposited layers of metals, particularly those on flexible webs, tend to be soft and easily rubbed off. These defects are particularly unacceptable where such layers are to be used as part of an imaging system consisting of a vapor-deposited metal layer and an overcoated photoresist or photopolymer layer. Marks, scuffs, kinks, or abrasions in the metal layer produce voids or areas in the film which contain no useful image, thus interrupting the faithfulness of the image. These photographic defective areas have been called by various names such as pinholes, cinch marks, scuffs, etc., depending on where and how the abrasion was produced. In order to avoid such defects, a protective resin layer is generally coated on the metal layer. This is often done in a separate coating operation on a different coating machine. The difficulty with this practice, however, is that the unprotected vapor-coated metal film must be wound after the vapor-coating operation to transport the material to the more conventional resin coater. Defects such as cinch marks, abrasions, and kinks are often produced during this winding operation.

In order to avoid the problems described above, several attempts have been made to vapor-deposite the metallic and organic layers in the same vacuum chamber, thus eliminating the need to wind the film in a roll between coating operations. One such process is described in U.S. 4,268,541. Here the vapor-deposition chamber is divided into 2 sections, by means of a partition, thereby separating the metal deposition area from the organic deposition section. Thus the organic protective layer is deposited over the metal layer without the need to rewind the roll in between the two coating operations.

The organic compounds used in U.S. Pat. 4,268,541 include polymers (for example, those derived from methacrylic acid and acrylic acid), low molecular weight organic compounds containing a carboxyl group (e.g., compounds such as abietic acid, isophthalic acid, behenic acid, terephthalic acid, phthalic acid, etc., and a few random compounds (e.g., Rhodamine B, rosin, a phthalocyanine, a monosaccharide, and an oligosaccharide).

The technique and materials described in U.S. 4,268,541 have been found to be suitable for only limited uses. The layer thickness of about 30-600 nm specified with those materials disclosed is not suitable for many imaging film constructions, and for many processing techniques. In particular, the friction properties of the coating cause layers of the coated material which are stacked or rolled to slide and move out of register. In rolled form, telescoping of the roll is quite serious. This can cause serious delays and expense in further use of the film.

Organic protection layers located between the metal layer and a photoresist layer can drastically affect the oxidizing or etching step and the quality of the resulting image. For example, excessive thickness of such layers may provide a preferential pathway for the developer or etch solution thereby resulting in image degradation or fine detail loss. This is especially true of material whose final designation is copy or contact reprographic work. Films such as these, called lith or contact films, depend on fine dot arrays to reproduce image tone. Fine dots (3 to 5%) may be undercut and etched away thereby degrading the quality of reproduction.

The relatively thick layer of some acid-containing protective materials such as disclosed in US-A-4 268 541 can also interfere with the etching of the metal by neutralising the alkaline metal etching solution. Such neutralisation inhibits the formation of an etched metal image and thus interferes with the formation of an image of acceptable quality.

Another attempt at overcoming the abrasion problems is described in Japanese Patent Publication No. 56/9736. In this case, the metal and the organic compound are deliberately coated as a single layer; i.e. the metal and organic vapours are substantially mixed in the vapour stream before they are deposited on the support. This is not completely satisfactory because the heated metal vapour can carbonise or decompose the organic material resulting in an unacceptable product. Also, the thickness of the layer is required to be at least 20 to 1000 mm. The scope of organic materials is also quite specific and generally emphasises organic acid materials.

According to the present invention there is provided a process for improving the abrasion resistance of vapour deposited metal layers which comprises vapour depositing a metal or metalloid layer on at least one surface of a substrate, characterised in that, before subjecting the metal layer to physical treatment or contact which would abrade the metal layer, there is vapour deposited onto said metal layer a 1 to 600 nm layer of organic material having a vapour pressure at 20°C equal to or less than that of 1-n-octanol, the material having:

a) a carbonyl group not part of a carboxyl group,

b) a phenoxy group,

c) an ester group, or

d) an alcohol group.

The substrate may be any surface or material onto which metal may be vapour-deposited. The substrate may be rough or smooth, transparent or opaque, and continuous or porous. It may be of natural or synthetic polymeric resin (thermoplastic or thermoset), ceramic, glass, metal, paper, fabric, and the like. For the most commercial purposes the substrate is preferably a polymeric resin such as polyester (e.g. polyethylene-terephthalate), cellulose ester, polycarbonate, polyvinyl resin (e.g. polyvinylchloride, polyvinylidene chloride, polyvinylbutyral, polyvinylformal), polyamide, polyimide, polyacrylate (e.g. copolymers and homopolymers of acrylic acid, methacrylic acid, n-butyl acrylate, acrylic anhydride and the like), polyolefin, and the like. The polymer may be transparent, translucent or opaque. It may contain fillers such as carbon black, titania, zinc oxide, dyes, pigments, and of course, those materials generally used in the formation of films such as coating aids, lubricants, antioxidants, ultraviolet radiation absorbers, surfactants, catalysts and the like.

The vapor-deposited metal layer may be any vapor-deposited metal or metalloid layer. According to the practice of the present invention, the term metal layer is defined as a layer comprising metal, metal alloys, metal salts, and metal compounds. The corresponding meaning applies to the term metalloid layer. The term metal in metal layer is defined in the present invention to include semi-metals (i.e., metalloids) and semiconductor materials. Metals include materials such as aluminum, antimony, beryllium, bismuth, cadmium, chromium, cobalt, copper, gallium, germanium, gold, indium, iron, lead, magnesium, manganese, molybdenum, nickel, palladium, rhodium, selenium, silicon, silver, strontium, tellurium, tin, titanium, tungsten, vanadium, and zinc. Preferably the metal is selected from aluminum, chromium, nickel, tin, titanium and zinc. More preferably the metal is aluminum. Metal alloys such as aluminum-iron, aluminum-silver, bismuth-tin, and iron-cobalt alloys are included in the term metal layer and are particularly useful. Metal salts such as metal halides, metal carbonates, metal nitrates and the like are useful. Metal compounds such as metal oxides and metal sulfides are of particular utility in imaging systems. Metal layers comprising mixtures of these materials such as mixtures of metal-metal oxides, metal-metal salts, and metal salts-metal oxides are also of particular interest.

The thickness of the vapor-deposited metal layer depends upon the particular needs of the final product. In imaging constructions, for example, the thickness should be at least about 3 nm. Generally, the layer would be no

The organic protective layer which may be 10 to 750 nm comprises a material with a vapour pressure at 20ºC no greater than that of 1-n-octanol selected from organic materials having

a) a carbonyl group which is not part of carboxyl groups,

b) a phenoxy group,

c) an ester group, or

d) an alcohol group.

The term "organic material" is used because the protective coating does not have to be a single compound or a monomeric compound. In addition to those types of materials, dimers, trimers, oligomers, polymers, copolymers, terpolymers and the like may be used.

The organic materials containing carbonyl groups which are not part of a carboxyl group, for example, include 1) amides, such as phthalamide, salicylamide, urea formaldehyde resins, and methylene-bis-acrylamide, and 2) anilides, such as phthalanilide and salicylanilide. It has been found that these organic materials may be used in layers as thin as 1 nm and provide good abrasion or mar protection. They may be used in thicknesses of up to 600 nm, but without dramatic improvement of results, and in fact often with some diminution of properties. A preferred range would be between 3 and 200 nm, more preferably between 5 and 100 nm, and most preferably at least 5 and lower than 30 or 20 nm.

The organic material containing ester groups includes such materials as polyester oligomers, low molecular weight polyester polymers (e.g. polyethylene-terephthalate, polyethyleneisophthalate, etc. having molecular weights between 5,000 and 50,000), diallyl phthalate (and its polymers), diallyl isophthalate (and its polymers), monomethyl phthalate, carboxylic acid alkyl esters, and the like.

The organic material containing phenoxy groups include such materials as Bisphenol A, and low molecular weight phenol formaldehyde resins (e.g. Resinox). The alochol containing materials would include 1-n-octanol, dodecanol, benzyl alcohol and the like.

The organic material should be vapor-depositable as this is the general method preferred for application of the protective layer. The organic material may, for example, be deposited in the apparatus and procedures disclosed in U.S. Patent No. 4,268,541. The partition or baffle described in that apparatus (e.g., Example 1) has not been found to be essential. The two vapor streams (i.e., metal and organic material streams) may be physically spaced apart or directed so that the coating zones for the two materials do not completely overlap. No serious problem has been found even when 50% of each of the coating zones overlap (so that at least 50% of the thickness of the metal layer consists essentially of metal, metal salts, metal compounds, and combinations thereof), although this is not a preferred construction. It is preferred that less than 25% of the total weight of the metal component be in such an overlapping or mixing zone and more preferably less than 10% or even 0% be in such zones. The recitation of a metal layer in the practice of the present invention requires, however, that at least a region of the coating, usually adjacent to the substrate, consists essentially of a metal layer without a dispersed phase of organic material therein.

The photoresist layer may be either a negative-acting or positive acting photoresist as known in the act. Positive acting photoresist systems ordinarily comprise polymeric binders containing positive acting diazonium salts or resins such as those disclosed, for example, in U.S. Patents Nos. 3,046,120, 3,469,902 and 3,210,239. The positive acting photosensitizers are commercially available and are well reported in the literature. Negative acting photosensitive resist systems ordinarily comprise a polymerizable composition which polymerizes in an imagewise fashion when irradiated, such as by exposure to light. These compositions are well reported in the literature and are widely commercially available. These compositions ordinarily comprise ethylenically or polyethylenically unsaturated photopolymerizable materials, although photosensitive epoxy systems are also known in the art. Preferably ethylenically unsaturated photopolymerizable systems are used, such as acrylate, methacrylate, acrylamide and allyl systems. Acrylic and methacrylic polymerizable systems are most preferred according to the practice of the present invention. U. S. Patents Nos. 3,639,185, 4,247,616, 4,008,084, 4,138,262, 4,139,391, 4,158,079, 3,469,982, U.K. Patent No. 1,468,746, disclose photosensitive compositions generally useful in the practice of the present invention. U. S. Patent No. 4,314,022 discloses etchant solutions particularly useful in the practice of the present invention.

Light-sensitive imaging elements of the present invention can be provided with a print-out image system by bonding a layer which is at least partially impervious to the generated gas on the surface of the layer generating the gas. The print-out system can be provided by adding a gas-generating light-sensitive material to the top layer and then overcoating the top layer with a gas-impermeable film.

The temporary image formed by the construction of the present invention is provided between the layer containing the photosensitive gas-generating material and the barrier layer. This is significantly different from normal vesicular imaging in which the bubbles of gas are usually trapped within the layer which generates the gas.

The barrier layer also does not have to be completely impervious to the generated gas. This is because the quasi-vesicular image formed is only temporarily required and may in fact desirably wash away (e.g., by removal of the barrier layer) in subsequent development or etching baths. The image formed can also be allowed to disappear by migration and evacuation of the temporarily trapped print-out image forming gas from beneath the barrier layer. The barrier layer therefore need only be sufficiently impermeable to the generated gas to provide an image for a few minutes. Thus a top coat over the gas-generating layer which had a mass transfer constant or permeability constant as defined in U.S. Patent No. 3,032,414 of not greater than

$$P_{max} = 1 \times 10^{-9} \; [cm^3 \; cm^{-2} \; sec^{-1} \; (cm \; Hg/cm(^{-1})]$$

preferably $1 \times 10^{-10}$ and more preferably $8 \times 10^{-10}$. This constant must be satisfied by the binder component of the layer if used as such, or by the layer with a modifier admixture added to a binder.

While the above upper limit of $P = 8 \times 10^{-10}$ is fairly critical, a lower limit is not equally well defined or critical; however materials with constants below $P_{min} = 8.6 \times 10^{-16}$ in most instances will be unsatisfactory.

The above values for P are referred to temperatures of approximately 30°C. They also generally refer to nitrogen, the gas which is at the present time most practical for purposes of scatter photography, although other gases such as $CO_2$ have been used. These P values for nitrogen diffusion however are, within the range specified, sufficiently close to those for other gases so that they serve satisfactorily for selecting a proper unmodified vehicle or for compounding with a modifier a vehicle that in itself does not conform to this permeability requirement.

The above permeability limits determine usefulness mainly as to photographic sensitivity and resolution. In general, these improve as the permeability is reduced. Furthermore copies which are thermally stable at ordinary storage temperatures are obtainable within these permeability ranges. To increase permeability with a modifier to permit fixing, an alternate type of modification is possible. A given resin may have permeability

0176693

higher than the upper limit of the operating range. This can be brought within the operating range by adding a modifier of low permeability. Thus the modifier is a method of adjusting the over-all permeability to some desired value.

The hardness of the vehicle polymer is not very critical with regard to permanence, since it is usually removed.

Vehicle materials according to the invention are further characterized, in purely physical, structural, terms, as primarily highly linear and saturated hydrocarbon chains essentially without crosslinking, such as obtained by polymerization of monomers with substituent groups preferably of small dimensions, made up of only a few elements and few atoms, and in many cases of a moderately electronegative character, imparting the polymer with a certain amount of polarity, or strong interchain cohesion, favoring close molecular fit and crystallinity, with closely adjacent molecule portions forming randomly distributed elementary structures interspersed with randomly distributed areas of lower coherence. These low cohesion areas are believed to constitute, or at least to favor the formation of, nucleating areas where the above described gas units tend to form. Many of the usable materials result from the interpolymerization of two ethylenic monomers resulting in the desirable properties of solubility, and color stability.

The gas-generating material may be any light-sensitive compound or mixture of compounds which generates a gas at standard temperature and pressure when irradiated. Halogen gas liberators, carbon monoxide or carbon dioxide liberators and any other such light sensitive gas generators would be useful. Most preferred is the well-known nitrogen liberator, photosensitive diazonium salts. The term photosensitive diazonium salts refers to all light-sensitive, aromatic diazonium compounds which generate nitrogen gas when struck by electromagnetic radiation, particularly in the visible, ultraviolet and infrared portion of the spectrum. This includes diazo quinones (encompassing diazo oxides and diazo amides, and diazo sulfides) as well as the more conventional light sensitive aromatic diazonium salts having simple or complex anions. These materials are well-known in the art as represented in U.S. Patent Nos. 4,247,616; 4,193,797; 4,189,320; 4,039,521; and 3,282,939 as well as in Light-Sensitive Systems, Kosar, John Wiley and Sons, Inc., 1965, pp. 202-214 and 276-282.

The various photosensitive imaging systems known to use these gas-generating materials which can make use of the present invention include for example, positive-acting photoresist systems (e.g., U.S. Patents 4,247,616 and 4,193,797), negative acting photoresists, and lithographic compositions (e.g., U.S. Patent 4,104,072 and Belgian Patent No. 881,956), diazonium-coupler dye forming systems (e.g., U.S. Patent Nos. 4,230,7891;4,168,171; 3,754,916; and 3,199,982) and dye bleach systems or leuco dye oxidation systems as known in the art. Each of these systems uses a diazonium salt as an ingredient in a light-senstive non-vesicular layer.

The invention may be most readily practiced by bonding the layer which is resistant to penetration of nitrogen gas as close as possible to or directly on the surface of the layer containing the gas generating photosensitive compound. Thus, the barrier is contiguous to the gas-generating layer. The best mode of positioning the barrier layer is on the surface of the imaging, gas-generating layer. The presence of intermediate layers, such as primer layers, tends to allow the gas to diffuse horizontally and reduce the quality of the image. In any case, intermediate layers should be less than 0.1 mm in thickness and preferably less than 0.05 mm. The intermediate layer should be permeable to nitrogen, for if it is not, it will act in the manner of a barrier layer and form a temporary image.

The barrier layer may be any natural or synthetic organic polymeric optically transmissive layer. Transparent binders and polymers such as polyvinyl alcohol, polyvinyl pyrollidone, gelatin, methyl vinyl ether copolymers, polyvinylidene chloride, acrylic latexes, and the like are most preferred. It is also particularly desirable to use solvent systems in laying down the barrier layer which do not penetrate the image forming layer. Since many imaging systems use organic solvents, a watersoluble or water-dispersible top-coat, for example, those of polyvinyl alcohol or polyvinylpyrollidone or various latices are particularly desireable. It is generally preferred that the barrier layer be transparent, but there are circumstances where translucency or transparency to only a limited range or wavelengths would be desirable. As long as the barrier layer allows some activating energy and preferably as portions of the visible spectrum to pass therethrough, the print-out image can be visible. The barrier layer is generally between 0.05 and 300 micrometers and preferably between 0.05 and 20 micrometers, more preferably between 0.10 and 5.0 and most preferably between 0.10 and 1.0 microns.

In a preferred practice of the invention, matting agents are added to the barrier layer. This provides a non-glossy appearance to the imageable element and can provide a control on the friction characteristics of the surface. Furthermore, if the material is to be stacked or rolled, the protuberance of the matting agent will prevent or reduce adherence between layers caused by the exclusion of air between them. Typical photographic matting agents such as polymethylmethacrylate and its copolymers, silica, and the like are generally useful.

One particularly beneficial side effect of the present invention with positive resist systems is enhanced developability in the imaged (irradiated) areas. This occurs because the vesicles produced by the generated gas are coincident with the more readily washed away portions of the light sensitive layer. The top coat is therefore most easily removed in the exposed areas because of reduced adhesion where the positive-acting radiation sensitive layer is also most readily etched or washed away.

The following Examples further illustrate practice of the present invention.

## Example 1

Using the apparatus described in US-A-4 268 541 without a baffle, three 2,000 metre rolls of a $10^{-4}$ m polyester web were coated by vacuum deposition with 70 nm of aluminum. During the same operation in the same vacuum chamber a layer of the organic material described below was applied to two of the rolls.

Roll A contained an organic layer (on top of the aluminum layer) consisting of Resinox, a phenol formaldehyde condensate resin made by the Monsanto Corporation.

Roll B was identical to Roll A except that an organic layer of Vitel 200, a low molecular weight polyester resin (approximately 10,000 molecular weight) made by and commercially available from Goodyear was applied to the aluminum layer. Roll C consisted of a control roll of vapour-coated aluminum film identical to rolls A and B with no organic protective coating.

None of these three rolls telescoped.

## Example 2

Using the apparatus of Example 1, the following materials were applied to vapour-coated aluminium webs in various thicknesses from 15 to 250 nm.

1) dimethyl terephthalate

2) phthalic anhydride

3) monomethyl phthalate

4) Dapon 35 - a diallyl phthalate prepolymer made by FMC Corp.

5) Bisphenol A

6) Epon 828 - an epoxy resin made by Shell Corp.

7) Michlers ketone

8) benzophenone

9) benzyl alcohol

10) salacylamide.

These materials were unrolled after coating and inspected with a 10X hand lens by transmitted light. The defects in an area of 177 $mm^2$ were counted and compared to those of a non-organic coated aluminum film prepared as a control. The control film exhibited defect levels over 100. The materials tested had defect levels of 30 or less. The control material that had no protective layer could be rubbed off using thumb pressure - the organic protective material could not. None of the above materials felt slippery and none produced any telescoping during or after rolling.

Example 3

Using the apparatus of Example 1, a coating was made on top of a 70 nm aluminum layer using Resinox (a low molecular weight phenol formaldehyde resin) as the organic layer. The organic layer was applied to produce an organic layer of about 5 nm thickness as determined by a Gaertner Ellipsometer.

The web was further coated with a resist layer of the type described in our copending Application Serial No. 350 737 filed in 1982. A control web consisting of only the 70 nm aluminum layer was additionally prepared.

After coating and drying these films were exposed to a 10 step Stauffer grey scale using 2 kw Berkey Ascor printing source (light to film distance 1 metre) for 15 seconds. The exposed films were developed in the processing solution described in Example 1 of US-A-4 314 022 for 30 seconds, at 38°C followed by a warm water wash. On inspection it was evident that the control film had a grey scale value of step 5, the terephthalic acid roll however had a grey scale value of 7 indicating a faster, more uncontrolled development.

## Example 4

Using the technique of Example 1, a Vitel 200 polyester coating was applied in a thickness of 10 nm to various metal layers including

1) tin
2) copper
3) aluminum/Mg (Al 94.8%; Mg 5.0%; Mn 0.1%; Cr 0.1%)
4) aluminum plus iron (ratio $Al_2Fe_5$)
5) nickel

A control non-organic coated layer was included for each metal while thumb action rubbing was able to remove the unprotected metal. The protected metal layers (organic coated) would not rub off.

CLAIMS:

1.    A process for improving the abrasion resistance of vapour deposited metal layers which comprises vapour depositing a metal or metalloid layer on at least one surface of a substrate, characterised in that, before subjecting the metal layer to physical treatment or contact which would abrade the metal layer, there is vapour deposited onto said metal layer a 1 to 600 nm layer of organic material having a vapour pressure at $20^{O}C$ equal to or less than that of 1-n-octanol, the material having:

a)   a carbonyl group not part of a carboxyl group,

b)  a phenoxy group,

c)   an ester group, or

d)   an alcohol group.

2.    A process as claimed in Claim 1, characterised in that at least 75% of the thickness of said metal or metalloid layer consists of a material selected from metals, metal compounds, metal salts and combinations thereof.

3.    A process as claimed in Claim 2, characterised in that said metal or metalloid layer consists of a material selected from metals, metal compounds, metal salts and combinations thereof.

4.    A process as claimed in any preceding claim, characterised in that the organic material is selected from amides, anilides, bisphenol A, phenol formaldehyde resins, low molecular weight polyesters, and alcohols having a vapour pressure at $20^{O}C$ no higher than 1-n-octanol.

5. A process as claimed in any one of Claims 1 to 3, characterised in that the organic material is selected from alkyl esters of carboxylic acids, polyester oligomers, and polyester polymers.

6. An article comprising a substrate having on at least one surface thereof a vapour deposited metal or metalloid layer characterised in that adhered to said layer there is a layer of 1 to 600 nm comprising an organic material having a vapour pressure at 20°C less than or equal to that of 1-n-octanol and having:

   a) a carbonyl group which is not part of a carboxyl group,

   b) a phenoxy group,

   c) an ester group, or

   d) an alcohol group.

7. An article as claimed in Claim 6, characterised in that at least 75% of the thickness of the metal or metalloid layer consists of a material selected from metals, metal compounds, metal salts and combinations thereof.

8. An article as claimed in Claim 6 or Claim 7, characterised in that the organic material is selected from amides, anilides, bisphenol A, phenol formaldehyde resins having a molecular weight between 5,000 and 50,000, and alcohols having a vapour pressure at 20°C no higher than 1-n-octanol.

9. An article as claimed in any one of Claims 6 to 8, characterised in that the organic material is selected from alkyl esters of carboxylic acids, polyester oligomers, and polyester polymers.

10.    An article as claimed in any one of Claims 6 to 9, characterised in that the organic material is overcoated with a photoresist layer.